# EUROPEAN PATENT APPLICATION

(11) **EP 1 336 853 A1**
(43) Date of publication of application: **20.08.2003**
(21) Application number: 02380036.0
(22) Date of filing: 19.02.2002
(51) Int. Cl.: G01R 19/15, G01R 31/02

(54) **Device that indicates failures in an electric circuit**

(71) Applicant: Gianelli, Miguel Angel, 1069 Buenos Aires (AR); Gianelli, Mariano, 1069 Buenos Aires (AR); Gianelli, Diego, 1069 Buenos Aires (AR)
(72) Inventor: Gianelli, Miguel Angel, 1069 Buenos Aires (AR); Gianelli, Mariano, 1069 Buenos Aires (AR); Gianelli, Diego, 1069 Buenos Aires (AR)
(74) Representative: Elzaburu Marquez, Alberto

(57) **Abstract**

The invention is a device indicator of failure to be collocated in an electrical circuit to give a luminous indication due to a failure produced in a sector of said circuit. The device including an insulation clamping base (1) that supports a pair of conductors (6,7) among which a resistance (5) and a light emitter (4) are disposed in parallel corresponding to the current, wherein the light emitter can be a lamp or a light emitter diode, the supply of said sector of the circuit being connected to said conductors.

## Description

The present invention refers to a device that indicates failures in an electrical circuit and, more particularly to a device that emits light when a failure occurs in the section of the circuit in which the same is included.

It is already known that in electric circuits there are various devices that indicate a failure occurring in it by means of audible signals or luminous signals, and also they currently are part of the general protection of the circuits.

In order to locate precisely the sector and also to proceed to the repair of the failure, it is necessary to locate the section where said failure has occurred.

Said failures normally constitute in an excess of the intensity of the electric current in the sector of the circuit in which said failure has occurred.

The device of the present invention indicates in a luminous manner the place in the section where the failure has occurred.

The main advantage of the device of the present invention is the simplicity of the same and its inclusion in the sector of the circuit in which the failure is to be detected.

Another advantage is that its inclusion in a branch of the sector of the circuit does not affect said circuit.

That main object of the invention is a device that indicates failures in an electrical circuit in order to emit a luminous signal due to a failure in a sector of said circuit, its novelty consisting in that it includes a base of insulant clamping that supports a pair of conductors among which, disposed in paralel there is a resistance and a light emitter corresponding to the electrical current, the supply of said sector of the circuit being connected to said conductors.

In a preferred embodiment of the invention said resistance is of the type of coefficient of resistance variable with temperature.

In a preferred embodiment of the invention said light emitter is an incandescent-filament lamp.

In that preferred embodiment of the invention said light emitter is a dode light emitter.

The main object as well as the advantages will be elucidated in the following description of a preferred embodiment of the invention, with reference to the drawings in which:
Figure 1 is a diagram of the device according to the invention, and
Figure 2 is another diagram of a variant of the device of the invention.

As it can be noticed in the drawings, the invention is a device that includes a clamping base 1, of an insulating material similar to te one used in printed circuits, that supports the conducting elements 6 and 7.

The resistance 5 and the low consumption lamp 4 are connected in parallel to said conducting elements 6 and 7

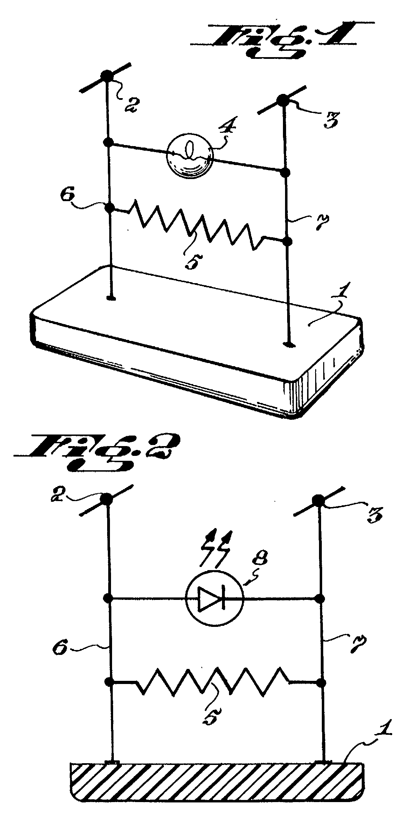

In the embodiment shown in figure 2, instead of the lamp 4 there is a light emitter diode (LED) 8.

The connection terminals 2 and 3 located at the ends of the conductors 6 and 7 are series connected to the supply of the circuit.

Due to the fact that the resistance 5 is chosen from a very low value for the normal current passing through said resistance 5 to determine the fall in tension to be minimum and, consequently the lamp 4 as well as the LED 8 not being excited to emit light.

When the current rises significantly due to a failure in the sector of the circuit to which the device is connected, said fall in tension will be larger and, therefore the lamp 4 of the LED 8 will emit light indicating that in that sector there is a failure.

If due to said failure, the passing current is extremely high, the resistance 5 may burn out, and also, the lamp 4 or LED 8 will emit light indicating that in that sector of the circuit there is a failure.

The latter may be avoided if the resistance 5 is of the type of resistivity coeficent variable with the temperature, which causes the rise in the value of the resistance without reaching the burning out of said resistance due o the limitation in current produced, but the fall in tension of the same is such that the lamp 4 or LED 8 emit light indicating that in that sector of the circuit there is a failure.

## Claims

1. A device indicator of failure in an electrical circuit in order to give a luminous indication due to a failure in a sector of said circuit, **characterized in that** it includes an insulant clamping base that supports a pair of conductors among which there area resistance and a light emitter disposed in parallel corresponding to the current, the supply of aid sector f the circuit being connected to said conductors.

2. A device indicator of failure in an electric circuit in accordance with claim 1 wherein said resistance is of the type of resistivity coefficient variable with temperature.

3. A device indicator of failure in an electric circuit in accordance with claim 1 wherein said light emitter is an incandescent-filament lamp.

4. A device indicator of failure in an electric circuit in accordance with claim 1 wherein said light emitter is a light emitter diode.
